# EUROPEAN PATENT SPECIFICATION

(11) **EP 2 954 760 B1**
(45) Date of publication and mention of the grant of the patent: **01.11.2017**
(21) Application number: 14822548.5
(22) Date of filing: 09.07.2014
(51) Int. Cl.: H05K 3/46, H05K 1/03, H05K 3/42, H05K 3/00

(54) **FUSION BONDED LIQUID CRYSTAL POLYMER CIRCUIT STRUCTURE**
SCHMELZVERBUNDENE FLÜSSIGKRISTALLPOLYMER-SCHALTUNGSSTRUKTUR
STRUCTURE DE CIRCUIT POLYMÈRE À CRISTAUX LIQUIDES FIXÉE PAR FUSION

(30) Priority: 11.07.2013 US 201361845088 P; 12.12.2013 US 201361915194 P
(43) Date of publication of application: 16.12.2015
(73) Proprietor: HSIO Technologies, LLC, Maple Grove, MN 55311 (US)
(72) Inventor: RATHBURN, James, Maple Grove, Minnesota 55311 (US)
(74) Representative: Atkinson, Ian Anthony
(86) International application number: PCT/US2014/045856
(87) International publication number: WO 2015/006393

(56) References cited:
- US-A- 5 046 238
- US-A1- 2002 179 334
- US-A1- 2006 274 510
- US-A1- 2006 281 303
- US-A1- 2007 267 138
- US-A1- 2010 143 194
- US-A1- 2010 300 734
- US-B2- 7 645 635
- US-B2- 8 203 207
- US-B2- 8 232 632
- US-B2- 8 247 702

## Description

### Technical Field

The present disclosure relates to a multi-layered high performance electrical circuit structure constructed using a liquid crystal polymer ("LCP") dielectric material, and corresponding methods that merge processes for printed circuit boards ("PCB") and semiconductor processing.

### Background of the Invention

As semiconductor and electronics markets have progressed, several technical factors have emerged that have significant impact to the electrical interconnects for "systems" whether they be computer, handset, tablet, automotive, medical, telecomm, data centers. Extreme increases in data traffic driven by internet, streaming video, smart phone, tablet and cloud computing are driving need for significant increases in bandwidth. Increases in data rate and functionality are driving significant wide scale architecture evolution. Advances in semiconductor packaging are driving significant density and routing challenges. Power and thermal management are challenges with low voltage systems to preserve battery life. Advances in semiconductor geometries have outpaced printed circuit geometries.

Traditional printed circuits are often constructed in what is commonly called rigid or flexible formats. The rigid versions are used in nearly every electronic system, where the printed circuit board (PCB) is essentially a laminate of materials and circuits that when built is relatively stiff or rigid and cannot be bent significantly without damage.

Flexible circuits have become very popular in many applications where the ability to bend the circuit to connect one member of a system to another has some benefit. These flexible circuits are made in a very similar fashion as rigid PCB's, where layers of circuitry and dielectric materials are laminated. The main difference is the material set used for construction. Typical flexible circuits start with a polymer film that is clad, laminated, or deposited with copper. A photolithography image with the desired circuitry geometry is printed onto the copper, and the polymer film is etched to remove the unwanted copper.

Flexible circuits are processed similar to that of rigid PCB's with a series of imaging, masking, drilling, via creation, plating, and trimming steps. The resulting circuit can be bent, without damaging the copper circuitry. Flexible circuits are solderable, and can have devices attached to provide some desired function. The materials used to make flexible circuits can be used in high frequency applications where the material set and design features can often provide better electrical performance than a comparable rigid circuit. Flexible circuits are very commonly used in many electronic systems such as notebook computers, medical devices, displays, handheld devices, autos, aircraft and many others.

Flexible circuits are connected to electrical system in a variety of ways. In most cases, a portion of the circuitry is exposed to create a connection point. Once exposed, the circuitry can be connected to another circuit or component by soldering, conductive adhesive, thermo-sonic welding, pressure or a mechanical connector. In general, the terminals are located on an end of the flexible circuit, where edge traces are exposed or in some cases an area array of terminals are exposed. Often there is some sort of mechanical enhancement at or near the connection to prevent the joints from being disconnected during use or flexure.

In general, flexible circuits are expensive compared to some rigid PCB products. Flexible circuits also have some limitations regarding layer count or feature registration, and are therefore generally only used for small or elongated applications.

Rigid PCBs and package substrates experience challenges as the feature sizes and line spacing are reduced to achieve further miniaturization and increased circuit density. The use of laser ablation has become increasingly used to create via structures for fine line or fine pitch structures. The use of lasers allows localized structure creation, where the processed circuits are plated together to create via connections from one layer to another. As density increases, however, laser processed via structures can experience significant taper, carbon contamination, layer-to-layer shorting during the plating process due to registration issues, and high resistance interconnections that may be prone to result in reliability issues. The challenge of making fine line PCBs often relates to the difficulty in creating very small or blind and buried vias.

The printed circuit industry has been driven by the mobile and handset market to achieve finer lines and spaces with higher density. The domestic circuit market has adopted laser direct imaging systems and laser drilled micro-vias over the last several years as advancements in fabrication techniques. In general, domestic suppliers can supply 75 micron lines and spaces with multi-layer construction, with the availability of 50 micron lines and spaces in some cases. The supplier pool is dramatically reduced below 50 micron lines and spaces, with blind and buried vias likely required.

Material sets available to traditional fabrication combined with the line and space capabilities drive the overall stack up for impedance control. For high speed applications, loss associated with glass weave and solder mask are an issue, and conventional via technology has become a major source of impedance mismatch and signal parasitic effects.

In general, signal integrity, high aspect ratio vias and line and space requirements limit the relationship between semiconductor packaging and the printed circuit board the chips are mounted to. Whether the application is a multi-layer rigid PCB, a flex circuit, or rigid flex there is a need for a high speed high density alternative.

US2006/274510, US2002/179334, US5046238 and US2007/267138 disclose prior art circuit structures and methods of fabricating such structures. US 2007/267138 discloses a method of making a multi-layered, fusion bonded circuit structure comprising the steps of attaching a circuitry layer to a major surface of a first LCP substrate, forming a plurality of recesses extending from a second major surface of the first substrate to the circuitry layer, plating the recesses to form a plurality of solid via studs, stacking and aligning a plurality of such LCP substrates, and fusion bonding the substrates.

### Brief Summary of the Invention

The present invention is directed to a method of making a multilayered fusion bonded circuit structure according to claim 1. Optional features are recited in dependent claims.

The present disclosure uses a liquid crystal polymer ("LCP") material as a circuit bearing dielectric material. The LCP can be used in several forms, such as a cast film, an injection molded coupon or wafer as well as in liquid resin form or a composite liquid material that includes LCP particles.

The present disclosure is directed to creating a circuit architecture that uses LCP material in ways that can be processed with the same equipment used to produce conventional circuits, as well as the laser system HSIO uses to produce connector and socket products. LCP has properties that make it ideal for high speed circuit fabrication. LCP have a low dielectric constant of 2.9 and is virtually impermeable to moisture. The ablation point is well suited for UV laser processing, and it has the unique availability of multiple melting temperatures. The present disclosure leverages those properties to create a method of creating circuits where the LCP material can either be pre-clad with copper or processed to accept electro-less copper deposition and fusion bonded using conventional lamination techniques.

In one embodiment, a series of films that have pre-formed or deposited conductor materials contained within the film are provided. The films are located and registered to each other and laminated under heat and pressure. The resulting circuit structure is created and the LCP material is fused together to make a contiguous LCP matrix with corresponding interconnect either held together by the fused LCP or a combination of localized molecular bonding of the conductive material such as copper.

In another embodiment, a circuit landscape is created by etched copper traces. A plating resist is applied and imaged to create via locations that are plated with electrolytic copper. After striping the resist the resultant field of vias is flooded with LCP resin or an alternate material loaded with LCP particles such that a lamination cycle the LCP material fuses. These two embodiments can be used alone or in combination.

The nature of the present process provides the potential for significant enhancement to traditional circuit techniques not generally possible with the normal circuit fabrication process alone. By combining methods used in the PCB fab and semiconductor packaging industries, the present disclosure enables fine line high density circuit structures not currently produced with attractive cost of manufacture. In addition, the high density circuit can be treated as a system of its own by incorporating printed transistors or other passive and active function.

The present disclosure permits the creation of circuit structures with lines and spaces below 50 micron and supports signal integrity beyond 40 GHz. The material sets can be processed with conventional circuit fabrication techniques and equipment. The solid metal vias provide superior electrical performance over conventional barrel plated or micro vias. The present disclosure is applicable to rigid, flexible and rigid flex circuits, as well as semiconductor packaging.

The present disclosure permits bulk conductive material to be added to create a very small low resistance vias to increase density and reduce line and feature pitch of the high density circuit. The printed circuit can be produced to replicate a traditional circuit, or it can be an interconnect to one or more members of a system embedded or incorporated.

One embodiment is directed to a method of making a multilayered, fusion bonded circuit structure. A first circuitry layer is attached to a first major surface of a first LCP substrate. A plurality of first recesses are formed that extend from a second major surface of the first substrate to the first circuitry layer. The first recesses are then plated to form a plurality of first conductive pillars of solid metal that substantially fill the first recesses. A plurality of second recesses are formed in a second LCP substrate corresponding to a plurality of the first conductive pillars. The second recess are plated to form a plurality of second conductive structures that extend between first and second major surfaces of the second substrate. The second major surface of the first substrate is positioned adjacent to the second major surface of the second substrate. The first conductive pillars are aligned with the second conductive structures. The stack is then fusion bonded to mechanically couple the first conductive pillars to the second conductive structures.

### Brief Description of the Several Views of the Drawing

Figure 1 is a side-sectional view of a method of making a high density circuit structure.
Figure 2 is a side-sectional view of the high density circuit structure of Figure 1 with a full metal via.
Figure 3 is a side-sectional view of a discrete layer to be added to the high density circuit structure of Figure 2.
Figure 4 is a side-sectional view of the discrete layer of Figure 3 fused to the high density circuit structure.
Figure 5 is a side-sectional view of an alternate discrete layer to be added to the high density circuit structure.
Figure 6 is a side-sectional view of the discrete layer of Figure 5 fused to the high density circuit structure.
Figure 7 is a side-sectional view of an alternate discrete layer to be added to the high density circuit structure.
Figure 8 is a side-sectional view of the discrete layer of Figure 5 fused to the high density circuit structure.
Figure 9 is a side-sectional view of a circuitry layer added to the high density circuit structure of Figure 4.
Figure 10 is a side-sectional view of a dielectric layer added to the high density circuit structure of Figure 9.
Figure 11 is a side-sectional view of a modification to the circuitry layer of Figure 10.
Figure 12 illustrates an electrical interconnect interfaced with a BGA device.
Figure 13 illustrates an electrical interconnect for a flexible circuit.
Figure 14 illustrates an electrical interconnect for an IC package.
Figure 15 illustrates an alternate electrical circuit for an IC package. Figures 16A and 16B are top and side views of a plurality of high density circuit structures combined with a low density PCB. Figure 16C is a side view of the PCB merged with the high density circuit structures.
Figures 17A-17G are side sectional views of an alternate method of constructing an alternate high density circuit structure.
Figures 18A-18D are side sectional views of a method of constructing an alternate high density circuit structure in accordance with an embodiment of the present disclosure.
Figure 19 is a side sectional view of a method of fusion bonding a plurality of circuit layers in accordance with an embodiment of the present disclosure.
Figure 20 is a side sectional view illustrated the plurality of circuit layers of Figure 19 after fusion bonding in accordance with an embodiment of the present disclosure.
Figure 21 is a side sectional view of solid metal vias added to the high density circuit structure of Figure 20 in accordance with an embodiment of the present disclosure.
Figures 22A and 22B are sectional views of co-axial circuit structures.
Figures 23A-23C illustrate an alternate method of making a circuit structure.

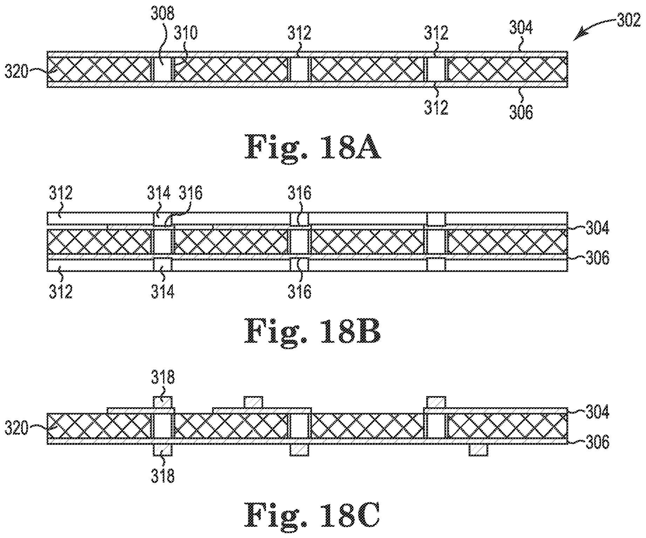

While the presently claimed invention is best illustrated in Figures 18A to 21 the other figures share common features with the presently claimed invention and are included for clarity and completeness.

### Detailed Description of the Invention

The present high density circuit structure can be configured as a low cost, high signal performance electrical interconnect assembly, which has a low profile that is particularly useful for desktop and mobile PC applications. The high density circuit structure can also be a portion of a socket or semiconductor package.

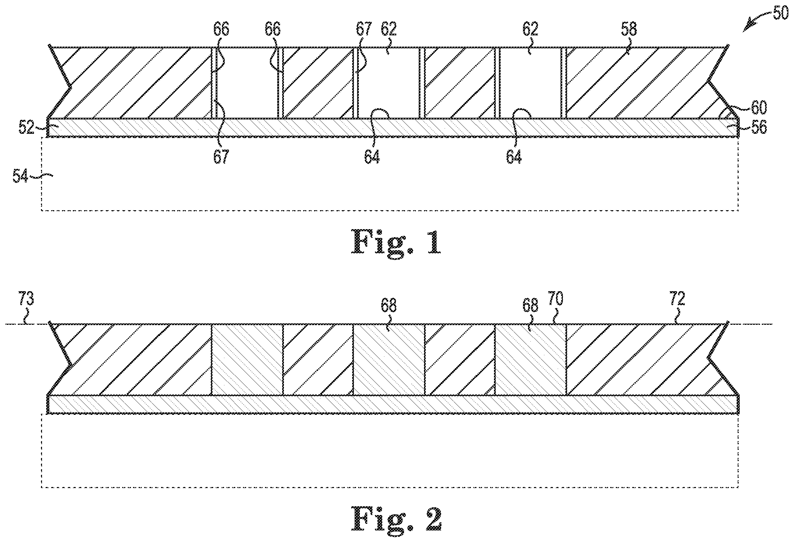

Figure 1 is a side cross-sectional view of a method of making the circuit structure 50. A copper foil 52 is preferably supported by base layer 54. The base layer 54 can be a sacrificial member that is removed at some point later in the process.

If the end product is a flexible circuit, the base layer 54 can be a material such as polyimide or liquid crystal polymer. If the final product is a rigid circuit board, the base layer 54 can be FR4 or one of many high speed laminates or substrates. If the final product is a semiconductor package, the base layer 54 can be a material such as FR4, BT resin of any one of a variety of laminate or substrate materials. The copper foil 52 can be pre-formed circuitry layer 56 or can be formed using a fine line imaging step to etch copper foil as is done with many PCB processes. The circuitry layer 56 can include fine line etching with spacing between copper traces of about 25 microns. It will be appreciated that conventional copper etching may be used to pattern thicker copper sheets (e.g., 1/4 ounce to 1/2 ounce i.e. 8¾ µm to 17½ µm thick), followed by fusion bonding of layers as discussed herein.

Liquid crystal polymer ("LCP") 58 is applied to surface 60 such that the circuitry 56 is at least partially in contact with the LCP 58. The LCP layer 58 may be a film or a liquid. The LCP layer 58 can be applied by screen printing, stencil printing, jetting, flooding, spraying etc. The LCP material is then imaged to create the recesses or vias 62 that expose the circuit locations 64. One benefit of imaging the LCP 58 is that the vias 62 do not need to be round as with traditional drilled vias. Any shape that can be imaged and will result in a grown full metal via 68 of the desired shape. Alternatively, the recesses or vias 62 can be formed using a laser direct imaging process known as LDI.

Liquid crystal polymers are a class of aromatic polyester polymers that are extremely unreactive and inert so as to be useful for electrical applications. Liquid-crystal polymers are available in melted/liquid or solid form. In solid form the main example of lyotropic LCPs is the commercial aramid known as Kevlar. In a similar way, several series of thermotropic LCPs have been commercially produced by several companies (e.g., Vectran / Ticona). LCP materials have a dielectric constant of about 2.9 at a frequency of about 20 GHz, a co-efficient of thermal expansion of about 8 to about 17 ppm/degree C, and a dimensional stability of less than about 0.1%.

The core LCP material 58 is processed to enable electro-less copper plating to adhere to the side walls 66 of the recesses 62, such as by using one or more of plasma treatment, permanganate, carbon treatment, impregnating copper nano-particles to activate the surfaces 66 to promote electroplating. The electro-less copper plating applied to the side walls 66 creates conductive structures 67 that are electrically coupled to the circuit layer 56. Additional discussion of the use of electro-less plating of the dielectric structure is disclosed in 14/238,638, filed February 12, 2014, entitled DIRECT METALIZATION OF ELECTRICAL CIRCUIT STRUCTURES and published as US2014/0192498.

As illustrated in Figure 2, higher deposition rate electroplate copper can be used to fill the recess 62 with bulk copper to grow a full metal, solid copper pillar or via structure 68 within the recesses 62. The conductivity of the bulk copper pillar 68 is on the order of about 1.68x10⁻⁶ ohm-cm. Additional discussion of the full metal, solid copper pillars is found in 13/413,724, entitled Copper Pillar Full Metal Via Electrical Circuit Structure filed March 7, 2012 and published as US2012/0168948.

The circuitry layer 56 is used to electroplate the circuit locations 64. The copper plating 68 adheres primarily to the base copper 58 at the locations 64. The LCP 58 and base layer 54 act as a resist to prevent copper plating except in the recesses 62. The resulting copper pillar 68 is preferably a solid copper structure, without voids.

The plating process can be controlled to a certain degree, but in some cases with fine pitch geometries and high speed circuits, the upper surfaces 70 of the copper pillars 68 may vary in topography or height relative to the exposed surface 72 of the LCP. Also, the LCP may vary in thickness slightly especially if liquid material is used. The copper pillars 68 are preferably planarized and the thickness of the LCP controlled between steps if needed to create a controlled dimension and flat reference plane 73 for the subsequent processing steps and layers.

For higher aspect ratio via connections 68, the process can be performed in a number of steps. For example, another layer of LCP 58 can be applied and imaged to expose the upper surfaces 70 of the previous copper pillars 68, with the next plating step increasing the height of the copper pillar 68 incrementally. Planarization is preferably performed between each layer.

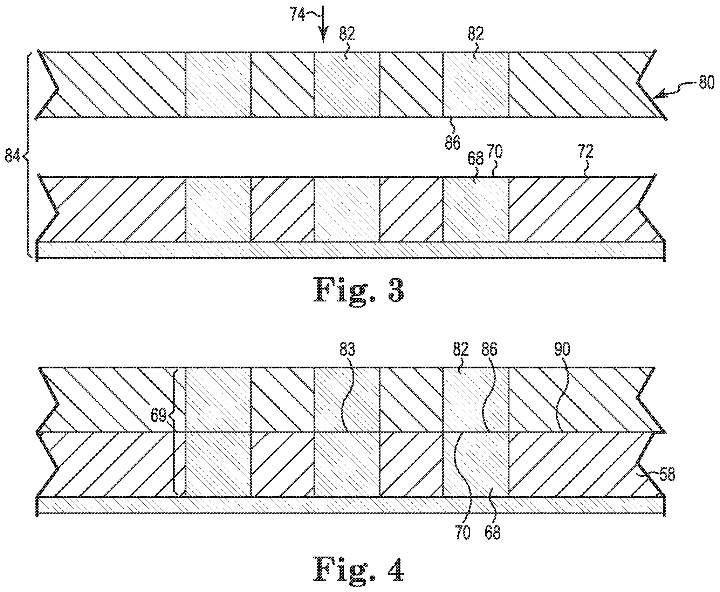

Figure 3 illustrates another method for creating higher aspect ratio via connections. Discrete LCP layer 80 is imaged and plated to create an array of copper pillars 82, as discussed herein. The layer 80 is then registered so the lower surfaces 86 of the copper pillars 82 are aligned with the upper surfaces 70 of the copper pillars 68. The stack 84 is then fusion bonded using heat and pressure 74.

As best illustrated in Figure 4, upper surfaces 70 of the copper pillars 68 are held in intimate contact with lower surfaces 86 of the copper pillars 82 by the fusion bond 90 of the LCP layers 58, 80. This mechanical connection can be augmented by the addition of a deformable conductive material, such as a conductive paste, located at interface 83 of the surfaces 70, 86.

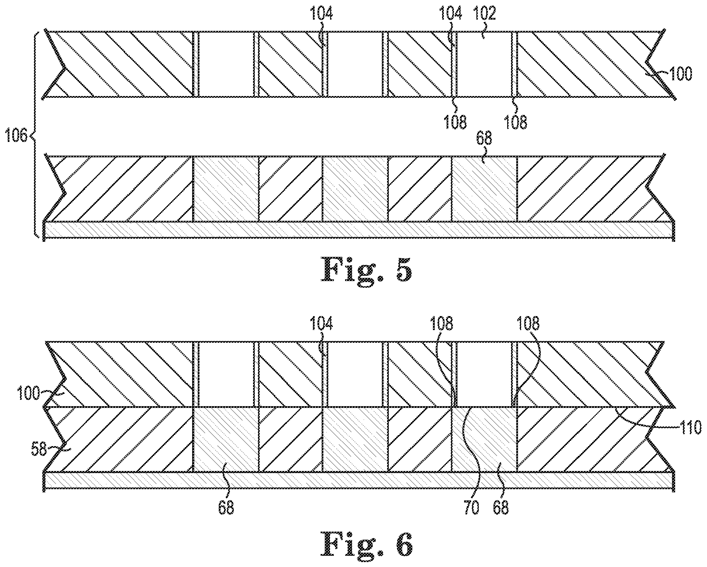

Figure 5 illustrate an alternate discrete LCP layer 100 with barrel plated vias 102 to form conductive structure 104. The conductive structures 104 are registered and aligned with the copper pillars 68. The stack 106 is then fusion bonded using heat and pressure as discussed herein.

As illustrated in Figure 6, the copper pillars 68 are held in intimate contact with lower surfaces 108 of the copper structures 104 by the fusion bond 110 of the LCP layers 58, 100. The vias 102 are then filled with bulk copper plating after the fusion bonding step to create the solid metal pillar 69 generally shown in Figure 4. The plating bonds directly to the upper surfaces 70 of the copper pillars 68, as well as the exposed surfaces of the conductive structures 104 in the layer 100, resulting in a mechanical and electrical connection between the copper pillars 68 and the conductive structures 104.

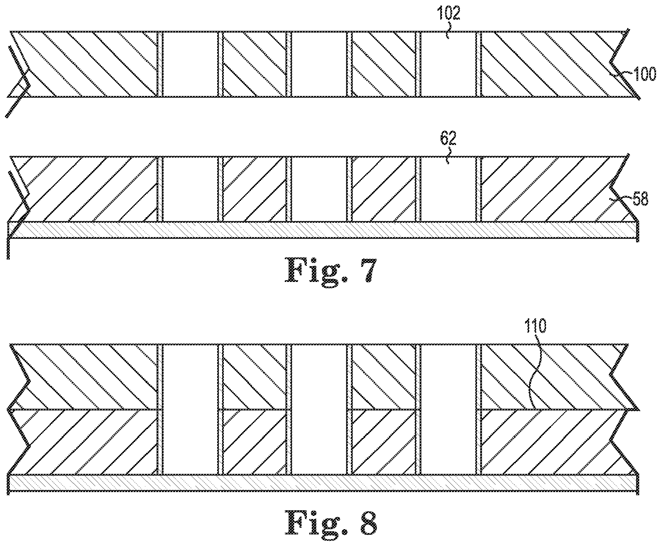

Figures 7 and 8 illustrate another variation of the configuration of Figures 5 and 6 in which the vias 62, 102 on both layers 58 and 100 are barrel plated. The subsequent bulk copper pillar extends between the layers 58, 100 across the plane of the fusion bond 110 to create the solid metal pillar 69 generally illustrated in Figure 4.

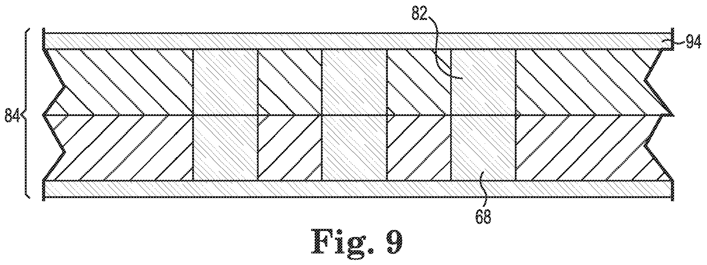

Figure 9 illustrates an optional copper layer 94 added to create the base for additional routing layers and to facilitate vertical via connection to subsequent layers in the stack 84. The present process creates the ability to stack full metal vias 68, 82 in subsequent deposition steps and/or layers to create a high aspect ratio via without the need to drill through the entire stack in one operation.

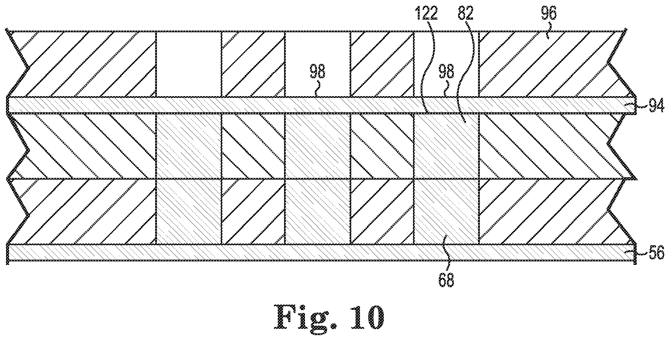

As illustrated in Figure 10, resist layer 96 can be added to the subsequent copper foil 94 and imaged to expose circuit locations 98. The LCP 96 flows and fills any recessed regions within a previous circuit landscape 94. The present process can also be used in combination with existing dry film techniques. For example, one or more of the layers can be a preformed dielectric film to leave air dielectric gaps between traces in the circuit layer 94.

In the illustrated configuration, the circuit locations 98 are electrically coupled with the tops surfaces 122 of the pillars 82 and connect to the circuit layer 94. The resist layer 96 protects circuit layers 56, 94 that are not to be etched and provides contact points to the previous pillar 68, 82.

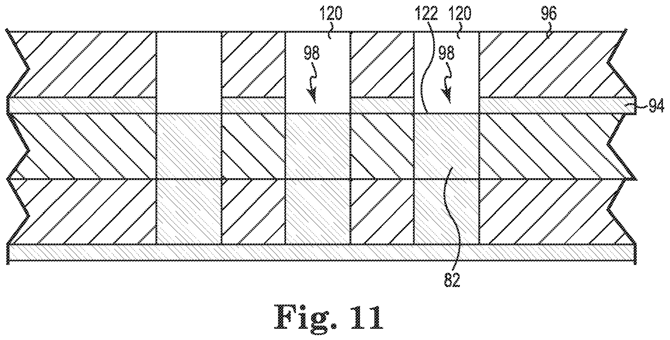

Figure 11 illustrates a subsequent etch process that removes the copper foil 94 at the locations 98 in the recesses 120 to provide access to top surfaces 122 of the pillars 82 to allow access for the next plating step to join the layers together. Depending on the material 96 and the desired final construction, the layer 96 can be stripped to provide a level to be planarized as the base for subsequent layers or the layer 96 can be left in place.

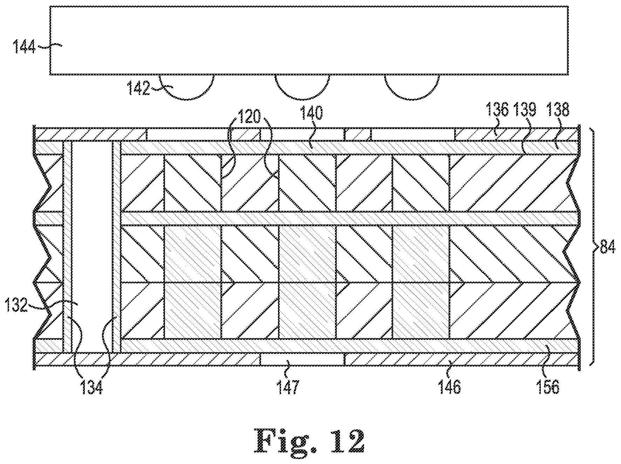

As illustrated in Figure 12, the recesses 120 can optionally be filled with similar LCP material 130, followed by a planarization step. A circuitry layer 138 is then added to the planarized surface 139. The stack 84 can be further processed with conventional circuit fabrication processes to add larger diameter through vias or through holes 132 with optional plating 134 as needed.

A solder mask 136 can be applied on circuitry layer 138 and imaged to expose device termination locations 140. The solder mask 136 can also be laser direct imaging. In one method, the solder mask 136 is a LCP. The locations 140 are configured to correspond to solder balls 142 on BGA device 144. In the illustrated configuration, bottom dielectric layer 146 is optionally deposited on circuitry layer 56 in a manner to expose selective regions 147.

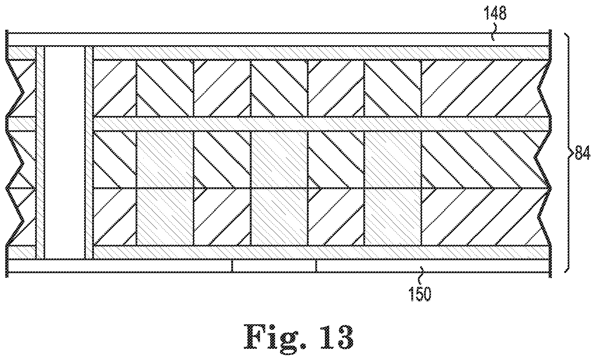

As illustrated in Figure 13, for flexible circuit applications the stack 84 is laminated with ground planes, cover layers, final finish 148, 150. In some applications the insulating areas can be applied by jet printing of polyimide or LCP as a final layer or as a combination of laminated film and jetted material.

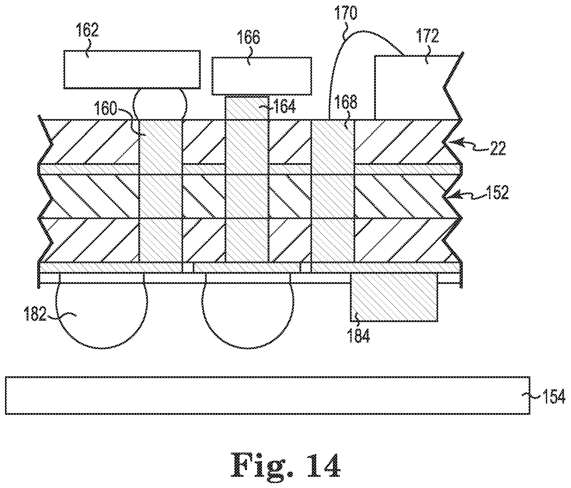

Figure 14 illustrates a configuration for semiconductor packaging applications. The stack 152 can be final processed with a variety of options to facilitate attachment of dies 162, 166, 172, as well as system level attachment to a PCB 154.

The pillar 160 is planarized to facilitate flip chip attach to the structure directly (see e.g., Figure 2) or to receive BGA device 162. In another configuration, plating 164 is extended to facilitate direct soldering of IC device die 166 with paste. In yet another configuration, plating 168 is wire bonded 170 to the IC device 172.

On the system interconnect side the structure can be processed to accept a traditional ball grid array attachment 182 for an area array configuration or plated with solder/tin etc. for a no lead peripheral termination. The structure can also be fashioned to have pillar or post extensions 184 to facilitate direct solder attach with paste and to provide a natural standoff.

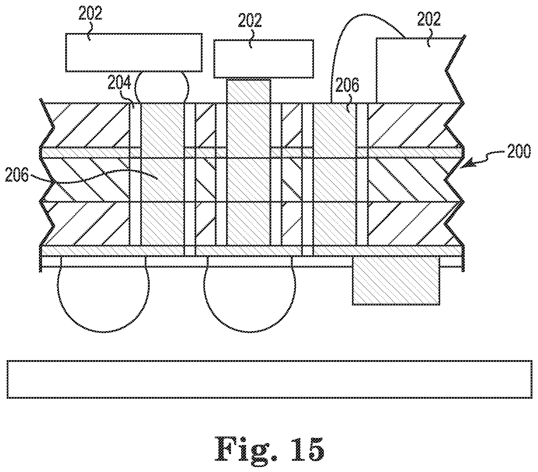

Figure 15 illustrates an electrical circuit 200 for a semiconductor packages 202 with LCP dielectric materials 204 surrounding the vias, internal circuits, terminations, and conductive structures 206. Internal circuits and terminations may also be added by imaging or drilling the core material with a larger opening than needed and filling those openings with an LCP material and imaging the desired geometry to facilitate conductive structure formation.

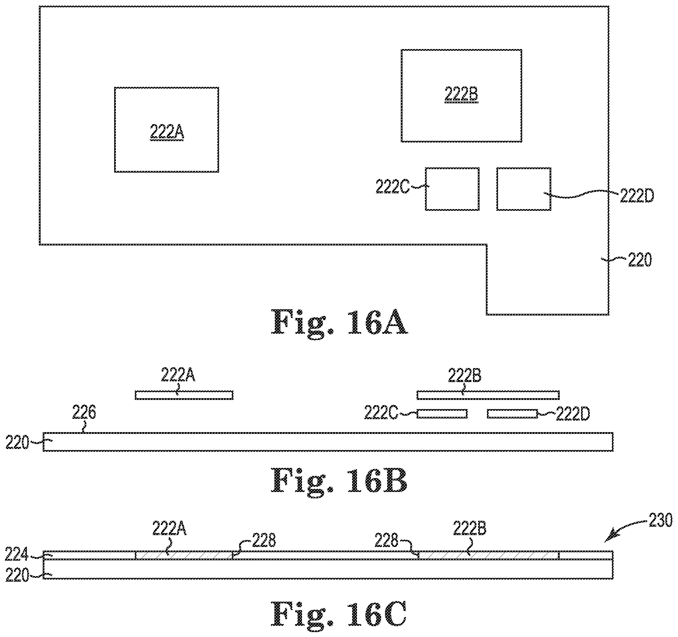

Figures 16A and 16B schematically illustrate the merger of a lower density circuit 220 with one or more liquid crystal polymer circuit structures 222A, 222B, 222C, 222D ("222") into the contiguous assembly of Figure 1C. The lower density circuit 220 may be a printed circuit board, a flexible circuit, or the like. The circuit structure 222 can be coupon or wafer configured as an 1C socket, a semiconductor package, or the like.

Dielectric material 224, such as a LCP, is optionally applied to the surface 226 of the low density circuit 220 so the location of the high density circuits 222 is at least partially defined and isolated. The dielectric material 224 may be a film or a liquid dielectric, such as a liquid crystal polymer. The dielectric material 224 can be a preformed structure or printed to expose the circuit locations 228 for the high density circuits 222, improving alignment of vias on the lower density main core 220 with the high density circuits 222. Where the surface 226 includes a LCP, the LCP circuit structures 222 is bonded using heat and pressure, as discussed herein.

If the circuit assembly 230 is a flexible circuit, the base layer can be a material such as polyimide or liquid crystal polymer. If the circuit assembly 230 is a rigid circuit board, the base can be FR4 or one of many high speed laminates or substrates. If the circuit assembly 230 is a semiconductor package, the base can be a material such as FR4, BT resin of any one of a variety of laminate or substrate materials. If the circuit assembly 230 is an electrical connector or socket, the base can be molded LCP, machined plastic, or a variety of films or substrate materials.

The liquid crystal polymer circuit structures 222 (also referred to as "coupons") are preferably made using the process described below. The liquid crystal polymer circuit structures 222 are then optionally merged with the low density circuit 220. The liquid crystal polymer circuit structures 222 can be fabricated in-situ directly on the low density circuit 220 using the processes described herein. The present method permits the liquid crystal polymer circuit structures 222 to be formed directly in the circuit locations 228, without having to extend the processing across the entire low density circuit 220.

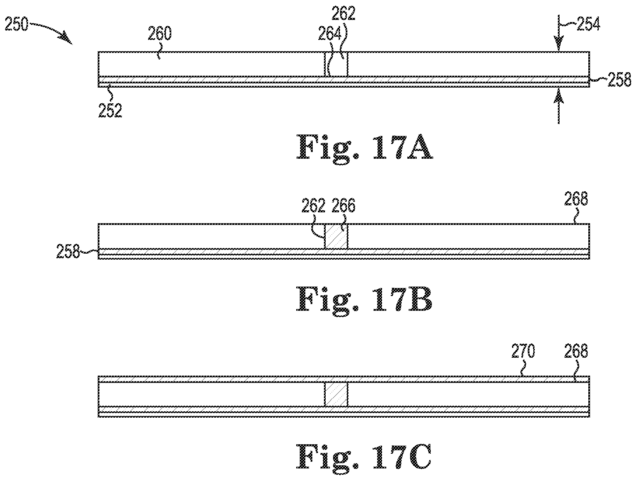

Figures 17A-17G illustrate an alternate method of making a circuit structure 250 using a LCP dielectric material 252. The LCP material 252 provides enhanced electrical performance, reduces the overall thickness 254 of the circuit structure 250. The resulting circuit structures can have 1/10 the thickness of a conventional PCB with comparable features.

Base layer 252 has a thickness of about 0.05 mm (0.002 inches) and is coated with a 8% µm thick (¼ ounce) copper layer 258. The copper layer 258 can be etched using conventional techniques to create the desired circuitry layer. The base layer 252 can optionally have copper foil located on both sides. In another arrangement, the base layer 252 can be a bare sheet of LCP that is processed to accept electro-less.

In one configuration, the LCP layer 260 is clad with 3 micron thick copper on the top surface. The laser ablation used to create vias 262 penetrates the 3 micron thick copper and the LCP 260 without damaging the base copper layer 258. In an alternate configuration, a top copper layer is electro-lessly plated onto the LCP layer 260 during a subsequent operation. Additional flash copper plate can be added to increase the thickness of the copper layer 268 as needed.

LCP layer 260 is located on the circuitry layer 258. Laser ablation is used to create via 262, without damaging the circuit structure 264 at the base of via 262. The vias 262 preferably has a diameter of about 12.7 µm (0.0005 inches) to about 127 µm (0.005 inches). The vias 262 preferably have an aspect ratio (height: diameter) of about 2:1 to about 1:1.

As shown in Figure 17B, electroplating is used to fill the opening 262 with solid copper 266 using the copper 258 as the electroplating buss. The full metal via 266 is electroplated up to surface 268. Over-plate can be removed using planarization techniques.

The present method permits the creation of solid or nearly solid filled, blind, or buried via 266 on very tight pitch of 25 micron or below. The LCP process permits via stacks that are 50 micron, 100 micron, and 150 micron high, about 25 times shorter than conventional PCB. The nature of the dielectric application and imaging structure allows for variable material content by position, by layer, and within various points on a given layer. The stack may be partly or completely produced digitally without tooling. Terminal shapes can be created in a variety of geometries depending on the terminal connected. Multiple interface points can be implemented to provide increased reliability or lower contact resistance. Electrical enhancements can include internal intelligence, test functions, data storage, shielding, RF antennae, power or signal management, capacitive coupling, analog to digital conversion, decoupling, Led indicators, display functions, battery capability, and the like.

As shown in Figure 17C, upper surface 268 of the LCP layer 260 is electro-less plated to create seed layer 270 for signal pad and ground plane bulk electrolytic build-up plating. The seed copper layer 270 can be removed with differential etch process, leaving the desired circuit pattern intact.

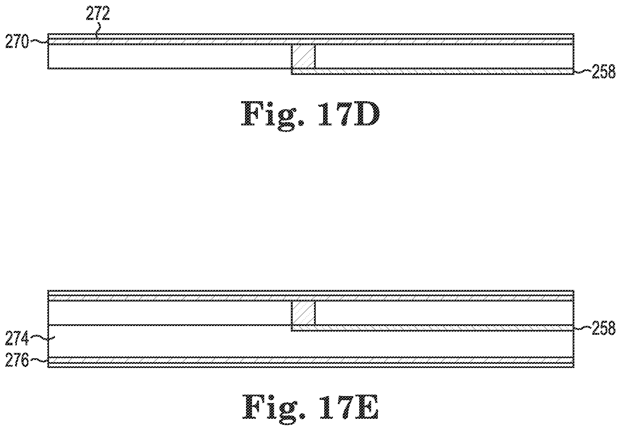

Figure 17D shows an arrangement in which resist layer 272 is applied to copper layer 270. The resist layer 272 is imaged to define the circuit pattern. The circuit pattern is electroplated restricted by the resist layer 272. In one configuration, the circuit pattern and the vias 266 are plated at the same time.

Also illustrated in Figure 17D, the copper layer 258 is processed to create the desired circuit structure using conventional techniques. The circuit structure in the layer 258 is bulk plated as needed.

As shown in Figure 17E, LCP layer 274 is applied to exposed lower circuit layer 258. One of the beneficial properties of the LCP material is it is available in multiple melting temperatures. A lower melt temperature LCP is used to level the circuit patterns with a fusion bonding process that fills in the regions between the circuit structure 258, as well as serves as the bonding agent for the next LCP layer as needed. The resulting structure has many advantages with solid copper full metal vias and traces that are surrounded by LCP with a common dielectric constant. The LCP material can also act as solder mask which is a significant benefit for high speed signals since solder mask is a lossy material. In the illustrated arrangement, LCP layer 274 also includes circuitry layer 276.

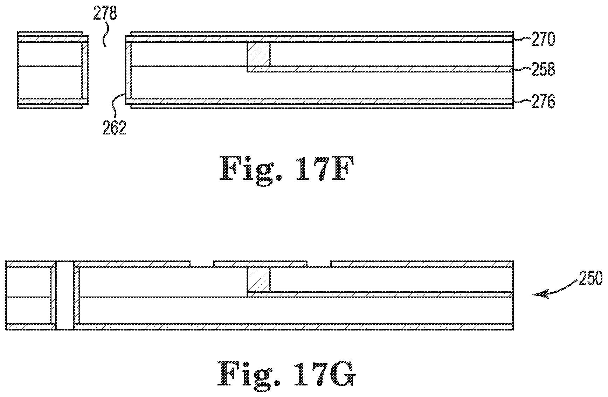

Figure 17F illustrates the formation of through holes or vias 278 drilled in the circuit structure 250. Plating 280 is added to the vias 278 to electrically couple the circuitry layers 270 and 276. As illustrated in Figure 17G, final finish and solder mask operations are then performed to create a LCP based circuit stack 250 that represents a thinner higher performance replica of a conventional circuit structure.

The present processing encompasses many variations depending on the intended design and results can be used directly as a flexible circuit or a rigid flex with a bonded stiffening member as appropriate. Multi-layer constructions with blind and buried vias basically combine layer stacks with some limitations regarding sequential build up with stacked vias. More complicated multi-layer constructions are also possible. The first uses the LCP layers for the fine lines and signal integrity, while the center region is a conventional rigid PCB constructed using conventional methods. A second method is a mother board - daughter card approach where the high density regions are fabricated with the LCP circuit stack and then merged with a larger format board built with conventional construction.

Figures 18A-18C illustrate circuit structure 300 built using LCP layers 320 in accordance with an embodiment of the present disclosure. The illustrated embodiment is a 12-layer PCB is assembled with three lamination cycles.

Figure 18A illustrates a center core 302 that is about 0.53 mm (0.021 inches) thick with a copper layer 304, 306 about 18 micron thick on the opposite surfaces. Vias 308 0.025 mm (about 0.001 inches) to about 0.1 mm (0.004 inches) in diameter are laser drilled through the center core 302. The vias 308 are barrel plated to add plating layer 310. The vias 308 are then filled with a conductive or non-conductive material and cap plated 312.

As illustrated in Figure 18B, power and ground circuitry are imaged in the copper layers 304, 306 and partial etched to leave about 3 microns of background copper between the traces to act as electrolytic plating bus. Resists layers 312 is applied and imaged to create vias 314 that expose locations 316 in the circuitry layers 304, 306. The vias 314 are plate to create solid metal pillars 318 and the resist layers 312 are removed.

Patterning of the resist layer 312 to define pattern plating structures, such as vias 314, with fine definition is accomplished with Laser Direct imaging in either a developed film process or direct ablation of cured resist.

As illustrated in Figure 18C, the plated vias 314 result in solid copper pillars 318 that extend above the circuitry layers 304, 306. In the illustrated embodiment, the solid copper pillars 318 have diameters of about 0.076 mm (0.003 inches). A differential etch is used to remove the 3 micron copper buss discussed above. The resist layer 312 constrains subsequent plating to create solid copper pillars 318 have a fine definition of about 100 micron on about a 300 micron pitch to be used for layer to layer interconnect.

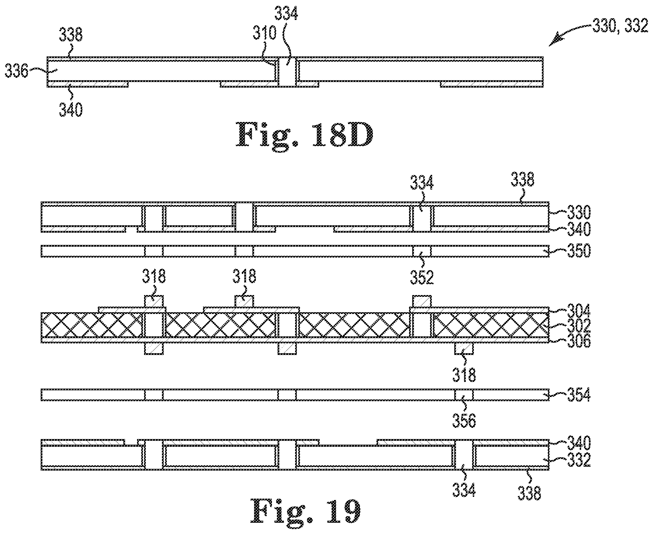

Figure 18D illustrates upper and lower LCP circuit stack layers 330, 332 created with vias 334 configured to receive the copper pillars 318 on the center core 302. In one embodiment, the vias 334 include barrel plating 335. The layers 330, 332 are created using the process discussed on connection with the center core 302. In particular, the layers 330, 332 are a sheet of LCP 336 about 0.051 mm (0.002 inch) thick with copper 338, 340 about 3 microns thick on both sides. The vias 334 are laser drilled with a diameter of about 0.076 mm (0.003 inches). A resist is applied and patterned so the bottom side signal circuitry 340 can be pattern plated to the proper thickness, the resist is stripped and differential etched to remove background copper. In another embodiment, conventional etching can be used to define circuitry 340.

In an alternate embodiment, one or more of the layers 302, 330, 332 are fabricated using conventional means. For example, the core layer 302 may be a conventional PCB, while the layers 330, 332 are fabricated using the techniques disclosed herein. In another embodiment, the ground and power layers can be located on a conventions circuit structure, with the signal layers located on LCP layers fabricated as discussed herein.

Figure 19 illustrate a process for laminating the layers 302, 330, 332 in accordance with an embodiment of the present disclosure. A film 350 of LCP or suitable alternate is pre-drilled with clearance holes 352 and aligned with the solid copper pillar 318 on the top surface of the center core 302 and the plated vias 334 in the upper LCP layer 302. A similar film 354 with pre-drilled holes 356 is aligned with the copper pillars 318 on the bottom of the center core 302 and the plated vias 334 on the lower LCP layer 332. The films 350, 354 are preferably a low melt point LCP material.

The current embodiment is also applicable to a hybrid high density/low density base board structure illustrated in Figures 16A-16C. With this design, the lower density PCB 302 is built with conventional technology. The solid copper pillars 318 of the present disclosure are added to the PCB 302 and configured to mate with corresponding vias 334 on the high density LCP circuit structures 330, 332. In this embodiment, the layers 330, 332 correspond with LCP circuit structures 222 in Figure 16C. The layers 302, 330, 332 are then bonded using heat and/or pressure as discussed herein. A similar example is a probe card or ATE board construction where the high density region in the center of the board is accomplished by merging a daughter card with appropriate routing to fan out the die patterns. Further discussion of such hybrid high density/low density circuit structures is found in PCT/US2013/030856 entitled Hybrid Printed Circuit Assembly with Low Density Main Core and Embedded High density Circuit Regions, filed March 13, 2013 and published as WO2014/011226.

The layers 330, 350, 302, 354, 332 are laminated and the LCP layers 350, 354 are fusion bonded to the adjacent layers. The copper pillars 318 are inserted into the plated vias 334 to form a mechanical and an electrical connection. The low melt temperature material in the layers 350, 354 fills the spaces between the traces of the circuitry layers 340, 304, 306 as it semi-flows in the fusion bonding process. The present process eliminates air entrapment that can cause blisters or bubbles during lamination. The process is self-leveling so planarity of the adjacent layers 330, 302, 332 is maintained. Surrounding the circuitry layers 340, 304, 306 in a common dielectric LCP provides a significant benefit from a signal integrity standpoint.

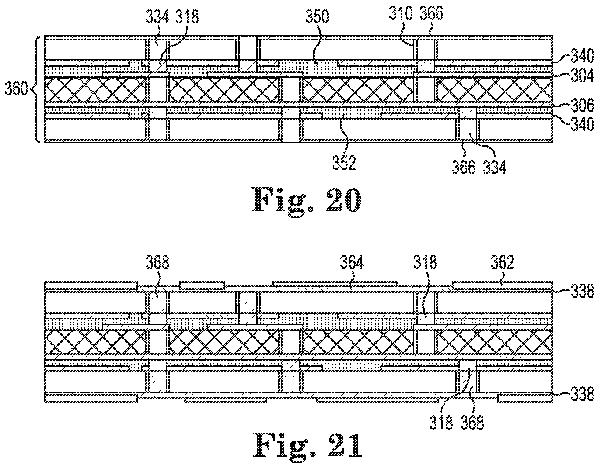

As illustrated in Figure 20, the circuit stack 360 is fused together by the LCP layers 350, 354. Signal integrity is greatly enhanced due to the circuitry 304, 306, 340, the plated vias 310 and the copper pillars 318 being surrounded by a LCP material with a similar dielectric constant.

As illustrated in Figure 21, the exposed electrolytic copper plating bus 338 is coated with resist 362 and imaged to expose the desired circuitry pattern 364 and to remove any cap plating 366 covering the vias 334 (see Figure 20).

The outer layer circuitry 364 is pattern plated to the proper thickness. During this plating process the vias 334 are preferably filled with bulk copper 368 that mechanically and electrically couples with the copper pillars 318. In an alternate embodiment, the barrel plating 310 is eliminated in favor of the bulk copper 368 deposited in the vias 334.

Any through holes are drilled and barrel plated as well. Solder mask is applied and final finish and legend print completes the construction. Any via locations that are not 100% filled with copper during the pattern plate operation are typically capped by solder mask.

The present disclosure enables circuit structures that are about 0.2 mm (0.008") thick compared to 3.175 mm (0.125") thick for the conventional back-drilled construction. The resulting performance is 60% improved over conventional construction beyond 20 GHz with equivalent design rules. Patterning of thin resist to define pattern plating structures with fine definition is accomplished with laser direct imaging in either a developed film process or direct ablation of cured resist. Fine definition of 25 micron traces with 37 micron spaces with base LCP material are possible. Very fine definition of 100 micron copper pillar full metal via formations on 300 micron pitch can be used for layer to layer interconnect.

Other circuit structures to which the present disclosure applies are disclosed in 13/410,943 entitled Area Array Semiconductor Device Package Interconnect Structure with Optional Package-to-Package or Flexible Circuit to Package Connection, filed March 2, 2012 and published as US2012/0161317; and 13/700,639 entitled Electrical Connector Insulator Housing, filed November 28, 2012 and published as US2013/0078860.

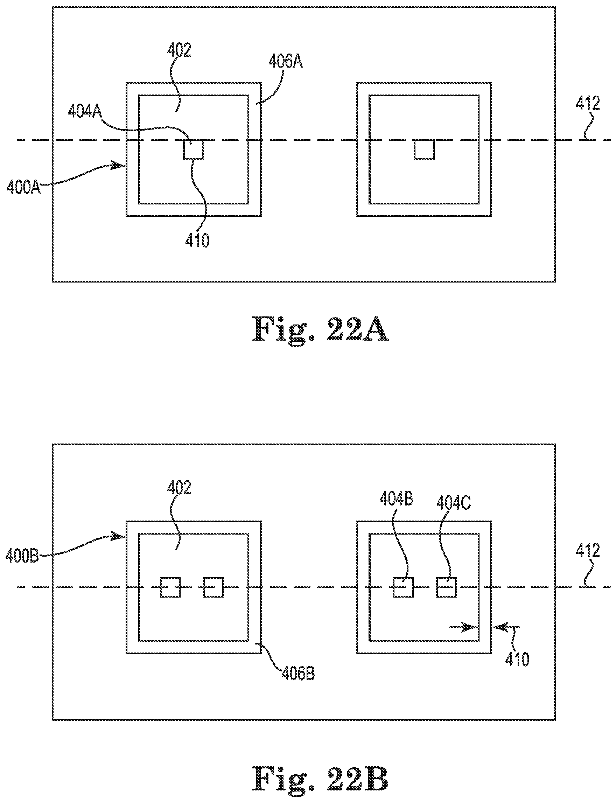

Figures 22A and 22B are a sectional view of co-axial structures 400A, 400B embedded in LCP material 402. The center conductors 404A, 404B, 404C ("404") are solid metal structures, preferably with a generally square cross-sectional shape. As discussed above, differential etching of the copper base layer and subsequent plating restrained by an imaged resist layer permits the fabrication of conductive traces with a substantially rectangular cross-sectional shape. Surrounding the center conductors 404 in the LCP material 402 provides greatly enhance signal integrity.

In one arrangement, the center conductors 404 have cross-sectional side dimensions of about 25 micrometers. The center conductors 404B, 404C are preferably separated by about 25 micrometers of LCP material. The co-axial conductors 406A, 406B also preferably have a width 410 of about 25 micrometers and are separated from the center conductors by about 25 micrometers of LCP material.

The center conductors 404 are optionally fabricated by creating a metalized layer 410 on the LCP to permit bulk copper plating to be formed in the channel formed by either a resist or the LCP material, as discussed herein. In one arrangement, the co-axial structures 400 are fabricated as two components that are subsequently fused along bonding lines 412.

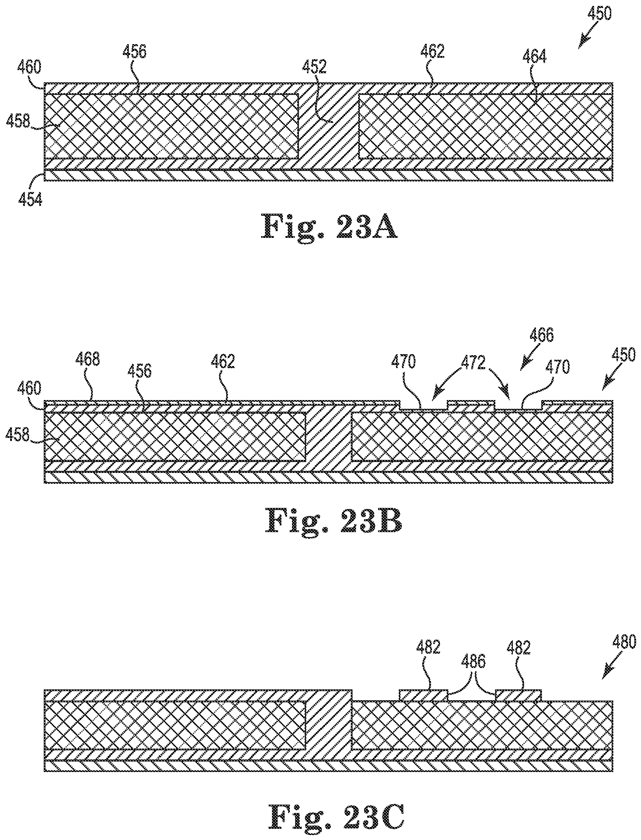

Figures 23A-23C illustrate an alternate method of making a circuit structure 450. This method is particularly applicable to creating fine lines and spaces using thicker standard 17.5 µm (½ ounce) or 8¾ µm (¼ ounce) thickness copper. Figure 23A illustrates full metal via 452 extending from base copper layer 454 up to top surface 456 of the LCP 458. Copper layer 460 deposited on top surface 456 of the LCP 458 is thicker than in other configurations, on the order of about at 0.178 mm (0.007 inches) thick.

The challenge for normal etching of thicker copper, such as the copper layer 460, is that the resulting circuit traces have a taper or trapezoidal cross-section due to the fact that upper surface 462 of the copper layer 460 etches faster than the lower surface 464. In order to etch down to the top surface 456 of the LCP layer 458, the spacing between adjacent circuit traces is usually larger than the actual trace, limiting the effective line and spacing between traces.

Figure 23B illustrates a resist pattern 466 created with resist layer 468. In the illustrated arrangement, the resist layer 468 is about 0.127 mm (0.005 inches) thick. The image 466 is created using a laser to ablate the resist layer 468 and a portion of the copper layer 460 to just above top surface 456 of the LCP layer 458. Using the laser to ablate the copper layer 460 creates substantially rectangular copper traces 482 (see Figure 23C). An UV laser vaporizes the resist 468 and the copper 460 without leaving deposits behind. In the present arrangement, a thin layer of copper 470 remains in the recesses 472 to prevent the laser from cutting through the LCP layer 458. In one arrangement, the thin copper 470 is on the order of about 3 microns thick.

Basically, the copper layer 460 is ablated down to a very thin layer 470 at the same time as the resist layer 468 is ablated. This approach allows starting with the thicker copper layer 460 and ablating down to the thin layer 470 using the laser to define the resist pattern 466, as well as give the etching a head start by removing most of the copper 460 that would normally need to be etched away. The present arrangement is able to define a circuit structure 480 (see Figure 23C) with the resolution and definition of the laser, rather than the resolution of conventional image and develop process used by conventional resist imaging.

After processing with the laser, the circuit structure 450 is etched to remove the remaining copper 470 in the recesses 472. The resist layer 468 protects the upper surface 462 of the copper layer 460 during the etching. The 3 micron copper 470 at the base of the recesses 472 is etched away very quickly during the differential etch, without degrading the remaining circuit pattern excessively.

As illustrated in Figure 23C, the resist layer 468 has been stripped and the circuit structure 480 remains. The copper 470 at the base of the recesses 472 is also gone. One of the benefits of the present arrangement is that resist ablation and pattern definition is done on the same machine as the full metal via 452 drilling so there is no registration issue as there is with conventional methods where the resist is imaged using a low power source that can expose photo sensitive material, but cannot ablate or vaporizes the resist layer 468 or the copper layer 460. The present method uses the laser to ablate the resist and the copper at the same step (although with a different power setting for copper). The same laser can also be used to drill the vias 452 in the same set-up.

When the fusion bond layer is applied, the space 470 between the traces 482 and any undercut adjacent to the traces 482 created during etching of the thin copper layer 470 are filled with LCP. Additionally, the circuit traces 482 are relatively thick (about 178 µm (0.007 inches)) with very straight, rectangular side walls 486 and little or no taper.

Where a range of values is provided, it is understood that each intervening value, to the tenth of the unit of the lower limit unless the context clearly dictates otherwise, between the upper and lower limit of that range and any other stated or intervening value in that stated range is encompassed within the embodiments of the disclosure. The upper and lower limits of these smaller ranges which may independently be included in the smaller ranges is also encompassed within the embodiments of the disclosure, subject to any specifically excluded limit in the stated range. Where the stated range includes one or both of the limits, ranges excluding either both of those included limits are also included in the embodiments of the present disclosure.

Unless defined otherwise, all technical and scientific terms used herein have the same meaning as commonly understood by one of ordinary skill in the art to which the embodiments of the present disclosure belong. Although any methods and materials similar or equivalent to those described herein can also be used in the practice or testing of the embodiments of the present disclosure, the preferred methods and materials are now described.

Other embodiments of the disclosure are possible. Although the description above contains much specificity, these should not be construed as limiting the scope of the disclosure, but as merely providing illustrations of some of the presently preferred embodiments of this disclosure. It is also contemplated that various combinations or subcombinations of the specific features and aspects of the embodiments may be made and still fall within the scope of the present disclosure. It should be understood that various features and aspects of the disclosed embodiments can be combined with or substituted for one another in order to form varying modes of the disclosed embodiments of the disclosure. Thus, it is intended that the scope of the present disclosure herein disclosed should not be limited by the particular disclosed embodiments described above.

Thus the scope of this disclosure should be determined by the appended claims. Therefore, it will be appreciated that the scope of the present disclosure fully encompasses other embodiments which may become obvious to those skilled in the art, and that the scope of the present disclosure is accordingly to be limited by nothing other than the appended claims, in which reference to an element in the singular is not intended to mean "one and only one" unless explicitly so stated, but rather "one or more."

## Claims

1. A method of making a multilayered, fusion bonded circuit structure comprising the steps of:
attaching a first circuitry layer (306) to a first major surface of a first LCP substrate (302);
forming a plurality of first recesses (308) extending from a second major surface of the first LCP substrate (302) to the first circuitry layer (306);
plating the first recesses (308) to form a plurality of first conductive pillars (318) of solid metal that substantially fill the first recesses (308), wherein the first conductive pillars (318) extend above the second surface of the first LCP substrate (302);
forming a plurality of second recesses (334) in a second LCP substrate (330) corresponding to a plurality of the first conductive pillars (318);
plating the second recesses (334) to form a plurality of second conductive structures (310) that extend between first and second major surfaces of the second substrate (330);
positioning the second major surface of the first LCP substrate (302) adjacent to the second major surface of the second LCP substrate (330);
aligning the first conductive pillars (318) with the second conductive structures (310)
positioning distal ends of the first conductive pillars (318) at least partially in the plated second recesses (334) of the second substrate (330) to form a mechanical and an electrical connection; and
fusion bonding the first and second LCP substrates (302;330) to mechanically couple the first conductive pillars (318) to the second conductive structures (310).

2. The method of claim 1 comprising the step of laser drilling the first and second recesses (308; 334).

3. The method of claim 1 comprising the step of planarizing the second major surfaces of the first and second substrates (302; 330) before the step of fusion bonding.

4. The method of claim 1 comprising the step of plating the second recesses (334) to form a plurality of second conductive pillars of solid metal that substantially fill the second recesses (334).

5. The method of claim 1 wherein the second conductive structures (310) comprise barrel plated vias, the method comprising the steps of plating the barrel plated vias to form a plurality of second conductive pillars of solid metal bonded to the first conductive pillars (318).

6. The method of claim 1 comprising locating the first conductive pillars (318) on a pitch of less than 150 micrometers.

7. The method of claim 1 wherein the first conductive pillars (318) have a height measured between the first and second major surfaces of less than about 150 micrometers.

8. The method of claim 1 comprising the step of attaching a second circuitry layer (338) to a first major surface of the second LCP substrate (330).

9. The method of claim 8 comprising the steps of:
bonding a third layer of LCP to an exposed surface of the second circuitry layer (338); and
laser drilling a plurality of vias from an exposed first major surface of the third layer to the second circuitry layer (338).

10. The method of claim 1 comprising the step of plating the second conductive structures (310) after the fusion bonding step to form a plurality of second conductive pillars of solid metal bonded to the first conductive pillars (318).

11. The method of claim 1 comprising the steps of:
forming a plurality of through holes corresponding to the first conductive pillars (318) and the second conductive structures (310) in a bond layer of low melt LCP (350);
positioning the bond layer (350) between the second major surfaces of the first and second LCP substrates (302; 330) with the through holes aligned with the first conductive pillars (318) and the second conductive structures (310) before the fusion bonding step; and
fusion bonding the bond layer (350) to the second surfaces of the first and second substrates (302; 330).

12. The method of claim 1 comprising the steps of:
preparing surfaces of one or more of the first or second recesses (308; 334) to receive electro-less plating; and
electro-less plating one or more of the first or second recesses (308; 334) before the plating step.

13. The method of claim 1 comprising the step of electrically coupling an IC device to a plurality of the second conductive structures (310) along the first surface of the second substrate (330).

## Patentansprüche

1. Verfahren zur Herstellung einer mehrlagigen, fusionsgebondeten Schaltungsstruktur, das die folgenden Schritte beinhaltet:
Anbringen einer ersten Schaltungsschicht (306) an einer ersten Hauptfläche eines ersten LCP-Substrats (302);
Bilden von mehreren ersten Aussparungen (308), die von einer zweiten Hauptfläche des ersten LCP-Substrats (302) zur ersten Schaltungsschicht (306) verlaufen;
Beschichten der ersten Aussparungen (308) zum Bilden von mehreren ersten leitfähigen Säulen (318) aus festem Metall, die die ersten Aussparungen (308) im Wesentlichen ausfüllen, wobei die ersten leitfähigen Säulen (318) über der zweiten Oberfläche des ersten LCP-Substrats (302) verlaufen;
Ausbilden von mehreren zweiten Aussparungen (334) in einem zweiten LCP-Substrat (330), entsprechend mehreren ersten leitfähigen Säulen (318);
Beschichten der zweiten Aussparungen (334) zum Bilden von mehreren zweiten leitfähigen Strukturen (310), die zwischen der ersten und der zweiten Hauptfläche des zweiten Substrats (330) verlaufen;
Positionieren der zweiten Hauptfläche des ersten LCP-Substrats (302) neben der zweiten Hauptfläche des zweiten LCP-Substrats (330);
Ausrichten der ersten leitfähigen Säulen (318) mit den zweiten leitfähigen Strukturen (310);
Positionieren von distalen Enden der ersten leitfähigen Säulen (318) wenigstens teilweise in den beschichteten zweiten Aussparungen (334) des zweiten Substrats (330) zum Bilden einer mechanischen und elektrischen Verbindung; und
Fusionsbonden des ersten und zweiten LCP-Substrats (302; 330), um die ersten leitfähigen Säulen (318) mechanisch mit den zweiten leitfähigen Strukturen (310) zu koppeln.

2. Verfahren nach Anspruch 1, das den Schritt des Laserbohrens der ersten und zweiten Aussparung (308; 334) beinhaltet.

3. Verfahren nach Anspruch 1, das den Schritt des Planarisierens der zweiten Hauptflächen des ersten und zweiten Substrats (302; 330) vor dem Schritt des Fusionsbondens beinhaltet.

4. Verfahren nach Anspruch 1, das den Schritt des Beschichtens der zweiten Aussparungen (334) zum Bilden von mehreren zweiten leitfähigen Säulen aus festem Metall beinhaltet, die die zweiten Aussparungen (334) im Wesentlichen ausfüllen.

5. Verfahren nach Anspruch 1, wobei die zweiten leitfähigen Strukturen (310) trommelbeschichtete Durchkontaktierungen umfassen, wobei das Verfahren die Schritte des Beschichtens der trommelbeschichteten Durchkontaktierungen zum Bilden von mehreren zweiten leitfähigen Säulen von an die ersten leitfähigen Säulen (318) gebondetem festem Metall beinhaltet.

6. Verfahren nach Anspruch 1, das das Positionieren der ersten leitfähigen Säulen (318) mit einer Teilung von weniger als 150 Mikrometern beinhaltet.

7. Verfahren nach Anspruch 1, wobei die ersten leitfähigen Säulen (318) eine Höhe, gemessen zwischen der ersten und zweiten Hauptfläche, von weniger als etwa 150 Mikrometern haben.

8. Verfahren nach Anspruch 1, das den Schritt des Anbringens einer zweiten Schaltungsschicht (338) an einer ersten Hauptfläche des zweiten LCP-Substrats (330) beinhaltet.

9. Verfahren nach Anspruch 8, das die folgenden Schritte beinhaltet:
Bonden einer dritten Schicht aus LCP an eine exponierte Fläche der zweiten Schaltungsschicht (338); und
Laserbohren von mehreren Durchkontaktierungen von einer exponierten ersten Hauptfläche der dritten Schicht zur zweiten Schaltungsschicht (338).

10. Verfahren nach Anspruch 1, das den Schritt des Beschichtens der zweiten leitfähigen Strukturen (310) nach dem Fusionsbondschritt zum Bilden von mehreren zweiten leitfähigen Säulen aus festem Metall beinhaltet, die an die ersten leitfähigen Säulen (318) gebondet sind.

11. Verfahren nach Anspruch 1, das die folgenden Schritte beinhaltet:
Bilden von mehreren Durchgangslöchern entsprechend den ersten leitfähigen Säulen (318) und den zweiten leitfähigen Strukturen (310) in einer Bondschicht von niedrig schmelzendem LCP (350);
Positionieren der Bondschicht (350) zwischen den zweiten Hauptflächen des ersten und zweiten LCP-Substrats (302; 330) mit den Durchgangslöchern, die mit den ersten leitfähigen Säulen (318) und den zweiten leitfähigen Strukturen (310) fluchten, vor dem Fusionsbondschritt; und
Fusionsbonden der Bondschicht (350) an die zweiten Flächen des ersten und zweiten Substrats (302; 330).

12. Verfahren nach Anspruch 1, das die folgenden Schritte beinhaltet:
Vorbereiten von Oberflächen von einer oder mehreren der ersten oder zweiten Aussparungen (308; 334) zum Aufnehmen von stromloser Beschichtung; und
stromloses Beschichten von einer oder mehreren der ersten oder zweiten Aussparungen (308; 334) vor dem Beschichtungsschritt.

13. Verfahren nach Anspruch 1, das den Schritt des elektrischen Koppelns eines IC-Bauelements mit mehreren zweiten leitfähigen Strukturen (310) entlang der ersten Oberfläche des zweiten Substrats (330) beinhaltet.

## Revendications

1. Procédé de fabrication d'une structure de circuits multicouches collée par fusion qui comprend les étapes consistant à :
rattacher une première couche de circuiterie (306) sur une première surface principale d'un premier substrat PCL (302) ;
former une pluralité de premiers évidements (308) qui se prolongent depuis une deuxième surface principale du premier substrat PCL (302) jusqu'à la première couche de circuiterie (306) ;
métalliser les premiers évidements (308) pour former une pluralité de premiers piliers conducteurs (318) d'un métal solide qui remplissent pratiquement les premiers évidements (308), où les premiers piliers conducteurs (318) se prolongent au-dessus de la deuxième surface du premier substrat PLC (302) ;
former une pluralité de deuxièmes évidements (334) dans un deuxième substrat PCL (330) en correspondance avec une pluralité des premiers piliers conducteurs (318) ;
métalliser les deuxièmes évidements (334) pour former une pluralité de deuxièmes structures conductrices (310) qui se prolongent entre les première et deuxième surfaces principales du deuxième substrat (330) ;
placer la deuxième surface principale du premier substrat PCL (302) dans une position adjacente à la deuxième surface principale du deuxième substrat PCL (330) ;
aligner les premiers piliers conducteurs (318) avec les deuxièmes structures conductrices (310) ;
placer les extrémités distales des premiers piliers conducteurs (318) au moins en partie dans les deuxièmes évidements métallisés (334) du deuxième substrat (330) pour créer une connexion mécanique et électrique ; et
coller par fusion les premier et deuxième substrats PCL (302 ; 330) pour coupler mécaniquement les premiers piliers conducteurs (318) aux deuxièmes structures conductrices (310).

2. Procédé de la revendication 1 qui comprend l'étape de perçage au laser des premiers et deuxièmes évidements (308 ; 334).

3. Procédé de la revendication 1 qui comprend l'étape d'aplanissement des deuxièmes surfaces principales des premier et deuxième substrats (302 ; 330) avant l'étape de collage par fusion.

4. Procédé de la revendication 1 qui comprend l'étape de métallisation des deuxièmes évidements (334) pour former une pluralité de deuxièmes piliers conducteurs d'un métal solide qui remplissent pratiquement les deuxièmes évidements (334).

5. Procédé de la revendication 1 où les deuxièmes structures conductrices (310) comprennent des vias plaqués au tonneau, le procédé comprenant les étapes de métallisation des vias plaqués au tonneau pour former une pluralité de deuxièmes piliers conducteurs d'un métal solide liés aux premiers piliers conducteurs (318).

6. Procédé de la revendication 1 qui comprend le positionnement des premiers piliers conducteurs (318) sur un pas de moins de 150 micromètres.

7. Procédé de la revendication 1, où la hauteur des premiers piliers conducteurs (318), mesurée entre les première et deuxième surfaces principales, est inférieure à environ 150 micromètres.

8. Procédé de la revendication 1 qui comprend l'étape consistant à rattacher une deuxième couche de circuiterie (338) sur une première surface principale du deuxième substrat PCL (330).

9. Procédé de la revendication 8, qui comprend les étapes consistant à :
lier une troisième couche de PCL sur une surface exposée de la deuxième couche de circuiterie (338) ; et
percer au laser une pluralité de vias depuis une première surface principale exposée de la troisième couche jusqu'à la deuxième couche de circuiterie (338).

10. Procédé de la revendication 1, qui comprend l'étape de métallisation des deuxièmes structures conductrices (310) après l'étape de collage par fusion pour former une pluralité de deuxièmes piliers conducteurs d'un métal solide liés aux premiers piliers conducteurs (318).

11. Procédé de la revendication 1, qui comprend les étapes consistant à :
former une pluralité de trous traversants en correspondance avec les premiers piliers conducteurs (318) et les deuxièmes structures conductrices (310) dans une couche de liaison PCL à température de fusion basse (350) ;
positionner la couche de liaison (350) entre les deuxièmes surfaces principales des premier et deuxième substrats PLC (302 ; 330) de manière à ce que les trous traversants soient alignés avec les premiers piliers conducteurs (318) et les deuxièmes structures conductrices (310) avant l'étape de collage par fusion ; et
coller par fusion la couche de liaison (350) aux deuxièmes surfaces des premier et deuxième substrats (302 ; 330).

12. Procédé de la revendication 1, qui comprend les étapes consistant à :
préparer les surfaces de un ou plusieurs des premiers ou deuxièmes évidements (308 ; 334) à la réalisation d'un placage anélectrolytique ; et
effectuer le placage anélectrolytique du un ou plusieurs des premiers ou deuxièmes évidements (308 ; 334) avant l'étape de métallisation.

13. Procédé de la revendication 1, qui comprend l'étape consistant à coupler électriquement un dispositif à circuit intégré à une pluralité des deuxièmes structures conductrices (310) le long de la première surface du deuxième substrat (330).
